**Europäisches Patentamt**

**European Patent Office**

**Office européen des brevets**

(19)

(11) Numéro de publication: **0 032 330**

**A1**

(12) ## DEMANDE DE BREVET EUROPEEN

(21) Numéro de dépôt: **80401747.3**

(22) Date de dépôt: **05.12.80**

(51) Int. Cl.³: **H 03 D 9/06**
**H 04 B 1/26**

(30) Priorité: **11.01.80 FR 8000613**

(43) Date de publication de la demande:
**22.07.81 Bulletin 81/29**

(84) Etats contractants désignés:
**DE GB NL**

(71) Demandeur: **THOMSON-CSF**
**173, Boulevard Haussmann**
**F-75360 Paris Cedex 08(FR)**

(72) Inventeur: **Del Giudice, Michel**
**THOMSON-CSF - SCPI 173, Bld Haussmann**
**F-75360 Paris Cedex 08(FR)**

(74) Mandataire: **Giraud, Pierre et al,**
**"THOMSON-CSF" - SCPI 173, bld Haussmann**
**F-75360 Paris Cedex 08(FR)**

(54) **Mélangeur subharmonique pour récepteur à ondes millimétriques et récepteur utilisant un tel mélangeur.**

(57) L'invention a pour but la fabrication d'un récepteur en ondes millimétriques dont l'oscillateur local est sur la fréquence moitié de la fréquence du signal à recevoir, le mélangeur subharmonique, y compris l'oscillateur local, étant situé dans un guide d'ondes unique (301).

Le mélangeur selon l'invention comprend un premier module (51) servant d'oscillateur local, comportant une diode oscillatrice entourée de diélectrique et reliée à une large métallisation, et un deuxième module (52) comportant un montage antiparallèle de deux diodes Schottky, module analogue au premier, les métallisations de ces deux modules étant en contact avec les plages métallisées (53, 54) d'un circuit imprimé (15) double face servant à la polarisation d'un module et à la sortie de signal de l'autre.

Application à la réception de signaux en ondes millimétriques, notamment au dessus de 50 GHz.

FIG.3

1

# MELANGEUR SUBHARMONIQUE POUR RECEPTEUR A ONDES MILLIMETRIQUES ET RECEPTEUR UTILISANT UN TEL MELANGEUR

L'invention concerne un mélangeur subharmonique, c'est-à-dire un mélangeur fonctionnant avec un oscillateur local dont la fréquence est la moitié de la fréquence d'un signal de réception radioélectrique, en vue d'effectuer le changement de fréquence nécessaire avant l'amplification et la détection du signal à traiter dans un récepteur en ondes millimétriques.

On sait qu'il est possible de réaliser le changement de fréquence dans un récepteur en ondes millimétriques, en utilisant un mélangeur symétrique que l'on dispose dans un guide d'ondes qui véhicule le signal à recevoir. Une solution avantageuse du point de vue industriel est décrite dans la demande de brevet N° 79.07 386 déposée le 23 Mars 1979 par la demanderesse. Elle comporte le montage en tête-bêche de deux modules, dispositifs contenant chacun une diode détectrice dans le guide d'ondes où règne le champ électro-magnétique du signal à traiter. Le mélangeur est couplé à un guide d'ondes où débite l'oscillateur local, d'une part, et, d'autre part, à un amplificateur de la fréquence de battement. Le récepteur doté de ce mélangeur présente l'avantage d'être très sensible au signal à recevoir et peu sensible aux variations d'amplitude de l'oscillateur local. Il présente toutefois deux inconvénients :

- nécessité de prévoir deux guides d'onde, l'un pour le signal à traiter, l'autre pour le signal local, ce qui oblige à recourir à des moyens de couplage complexes;
- nécessité de fournir un oscillateur local à la même fréquence que le signal à recevoir, donc d'autant plus onéreux et d'autant moins puissant que cette fréquence est plus élevée.

L'invention permet de conserver les avantages de la

2

première solution, tout en évitant les inconvénients signalés, même en très haute fréquence. En effet, un seul guide d'ondes est nécessaire et le type de mélangeur subharmonique adopté est peu sensible aux fluctuations d'amplitude de l'oscillateur local.

Le mélangeur subharmonique selon l'invention est du type comportant un guide d'ondes véhiculant le signal à recevoir. Il est principalement caractérisé en ce qu'il comporte dans le même guide d'ondes un oscillateur local et un organe mélangeur à deux diodes semiconductrices en montage antiparallèle, un couplage capacitif existant entre l'organe mélangeur et l'oscillateur, et des moyens de raccordement avec l'extérieur du guide assurant la sortie du mélangeur et l'alimentation de l'oscillateur local et de l'organe mélangeur.

L'invention sera mieux comprise, et d'autres caractéristiques apparaîtront, au moyen de la description qui suit, et des dessins qui l'accompagnent, parmi lesquels :

- la figure 1 représente un mode de réalisation de l'oscillateur local ;

- la figure 2 représente un mode de réalisation, selon l'invention, de l'organe mélangeur ;

- la figure 3 représente schématiquement un mélangeur selon l'invention ;

- les figures 4 et 5 représentent des détails de réalisation d'un mélangeur selon l'invention.

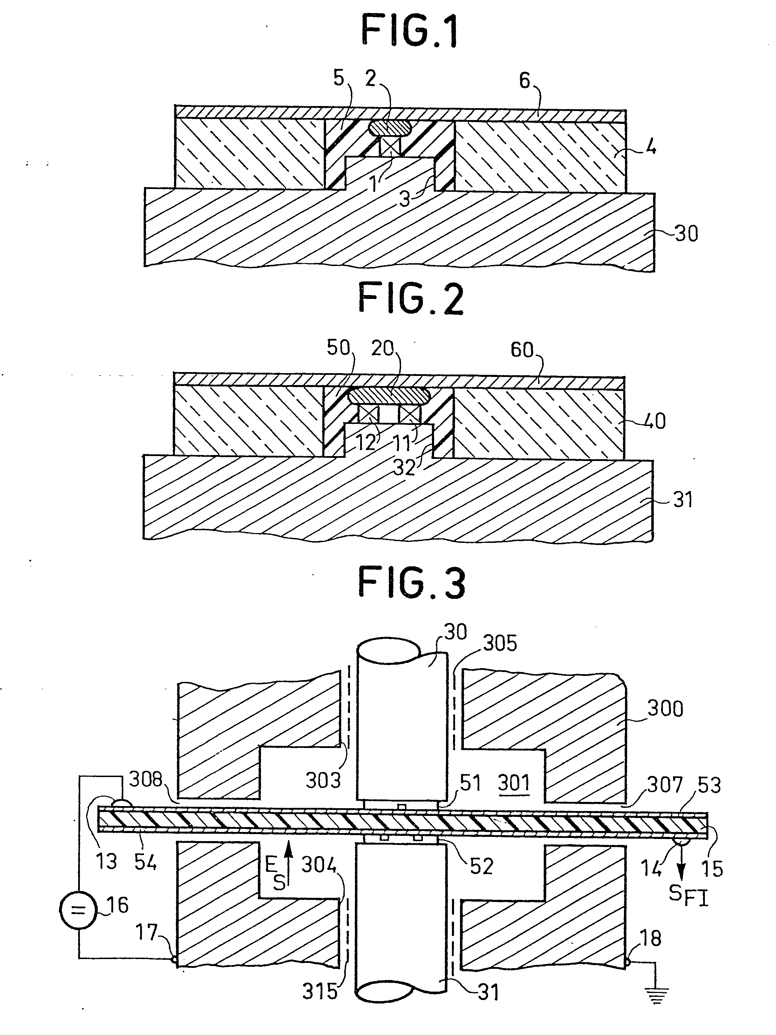

Figure 1, on a représenté un oscillateur local réalisé sous la forme de module, au sens de la demande de brevet précitée. Le module comporte une diode semiconductrice du type Gunn ou à avalanche, capable d'osciller en ondes millimétriques. Cette diode 1 est montée sur une plateforme 3 faisant saillie sur un support métallique 30.

La diode 1 est surmontée d'un disque 2 en or, de dimensions plus grandes que la diode elle-même. La plateforme 3 est

3

entourée d'un anneau 4 en verre de type "quartz" (silice
fondue) à section carrée ou rectangulaire. L'invervalle
laissé libre entre la partie centrale de la source et
l'anneau de verre est rempli d'une résine 5 de coefficient diélectrique voisin de celui du verre constituant
l'anneau, et par ailleurs capable de résister à des
températures élevées de l'ordre de 300 à 500° C ; c'est
par exemple de la résine polyimide. Une métallisation 6 recouvre la partie supérieure, notamment le
disque 2. Cette métallisation constitue l'électrode de
polarisation de la source, le support 30 constituant
la masse.

Dans une telle source, la fréquence d'oscillation
dépend des dimensions (diamètre et hauteur) de l'anneau
de verre et du diamètre de la métallisation.
On voit donc que l'on peut préaccorder la source en
choisissant non seulement le diamètre mais la hauteur,
et cela en gardant le même support 30 et la même diode
1, à condition de faire varier l'épaisseur du plot 2.

Figure 2, on a représenté un organe détecteur réalisé sous la forme d'un module assez semblable au module
de l'oscillateur local mais contenant toutefois deux
diodes semiconductrices 11 et 12, par exemple du type
Schottky, au lieu d'une seule de type Gunn ou à avalanche. Ces diodes sont montées à côté l'une de l'autre,
en montage antiparallèle, sur une plateforme 32 faisant
saillie sur un support métallique 31, d'une part, et,
d'autre part, un disque 20 faisant la liaison avec une
métallisation 60 préadaptant le module détecteur sur la
fréquence du signal. L'une des diodes est soudée à la plateforme du côté de la jonction "métal-semiconducteur" (non
représenté figure 2) s'il s'agit d'une diode Schottky, et
l'autre diode est au contraire soudée au disque du
côté de la jonction.

Figure 3, on a représenté en coupe un guide d'ondes

4

300, à section restangulaire 301, dans lequel se propage le signal à traiter dans le mélangeur, signal dont la composante électrique $E_S$ du champ électromagnétique est parallèle au petit côté du rectangle 301.

Dans les parois opposées qui sont parallèles aux grands côtés du rectangle 301, existent des ouvertures taraudées 303 et 304, dans lesquelles pénétrent les supports 30 et 31 des modules sur lesquels des filetages 305 et 315 ont été pratiqués à cet effet.

Le module oscillateur local 51 et le module détecteur 52 sont portés par leurs supports respectifs 30 et 31. Ces supports sont vissés à force pour maintenir au contact les métallisations de ces modules avec des métallisations 53 et 54 situées sur les faces d'un circuit imprimé 15 de forme allongée qui émerge du guide latéralement par des fentes 307 et 308.

Le module 51 est alimenté par une source de tension continue 16 branchée entre deux plots de raccordement 13 et 17 aménagés sur la métallisation 53 et sur le guide 300.

Le module 52 n'est pas normalement polarisé, étant alimenté par l'induction du champ du signal à recevoir et de celui du signal local à travers le diélectrique du circuit imprimé 15. Les signaux de sortie $S_{FI}$ sont prélevés entre un plot 14 aménagé sur la métallisation 54 du circuit imprimé 15 et une masse raccordée au guide 300 par un plot 18.

Dans certaines utilisations, on peut être conduit à polariser le module 52 pour obtenir une détection efficace. En ce cas, on utilise des moyens analogues à ceux qui permettent d'alimenter le module 51 en courant continu. Un découplage par inductance et capacité (non représenté) est alors monté de façon classique pour extraire le signal $S_{FI}$ de fréquence intermédiaire.

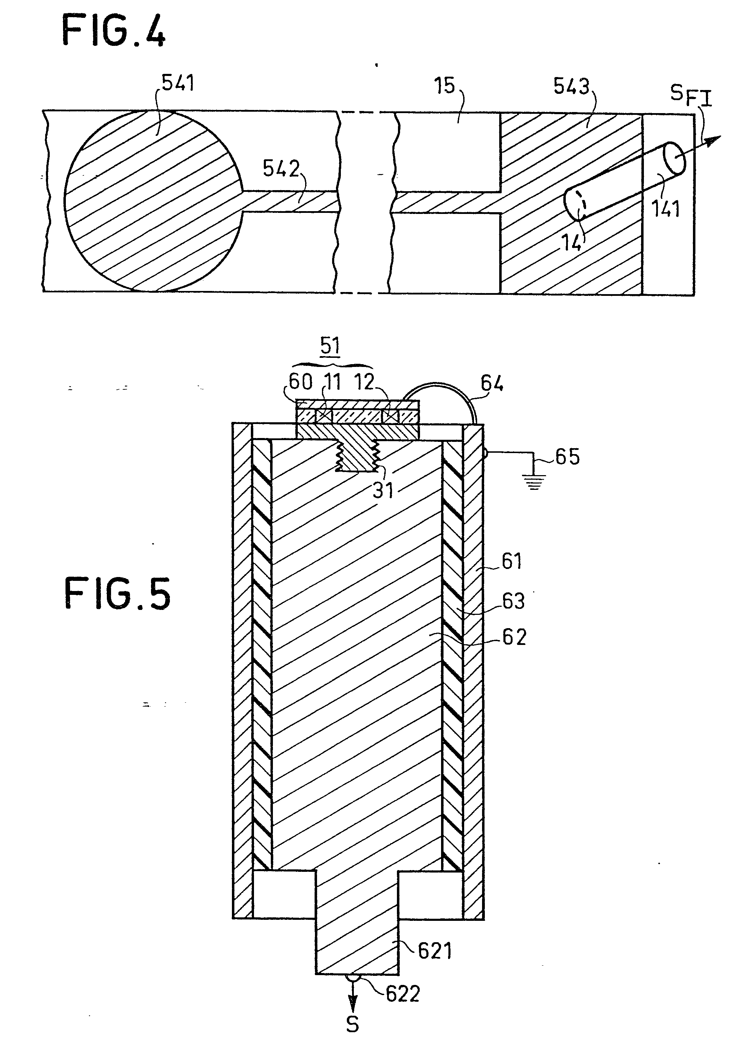

Figure 4, on a représenté le circuit imprimé 15 par une vue en plan montrant la métallisation 54. Cette

5

métallisation comprend une première partie de forme circulaire 541, destinée à entrer en contact avec la métallisation du module 52, suivie d'une deuxième partie constituée par une bande 542 de faible largeur et terminée par une troisième partie 543 de forme rectangulaire, à laquelle est soudé le plot 14 et un fil de connexion 141 de sortie du signal $S_{FI}$.

Le récepteur (non représenté) utilisant le mélangeur fait également partie de l'invention. Il comprend notamment :

- une antenne de réception du signal hertzien ;
- le guide d'ondes du même signal (représenté en coupe figure 3) ;
- un filtre de fréquence intermédiaire ;
- un amplificateur de fréquence intermédiaire ;
- des éléments classiques de détection de signal à basse fréquence et d'amplification.

Le fonctionnement du récepteur est le suivant :

Le module oscillateur local émet de l'énergie électromagnétique. Bien que ne se propageant pas dans le guide, cette onde "pompe" les diodes du module mélangeur subharmonique de telle sorte qu'il se produit dans ces diodes un battement entre le signal local et le signal à recevoir, présent dans le guide d'ondes, d'où résulte la production du signal intermédiaire, lequel est recueilli et transmis par la métallisation du module de détection.

Dans la création de la fréquence intermédiaire, les fluctuations associées à l'oscillateur local sont pratiquement éliminées.

Dans une variante du mélangeur selon l'invention, on utilise, pour créer la polarisation du module oscillateur local, et pour recueillir le signal de fréquence intermédiaire émanant du module mélangeur, un dispositif représenté figure 5 dans le cas où il s'applique au module 52.

Le dispositif de la figure 5 est un sous-ensemble destiné à être introduit dans l'ouverture 304 du guide 301. Il comporte un manchon métallique 61, par exemple en cuivre. Dans ce manchon est inséré une pièce métallique 62, en cuivre, revêtue d'une couche d'isolant 63. La pièce 62 comporte un trou taraudé où est vissé le support 31 du module 52 comportant les diodes 11 et 12, et leur électrode 60. Cette électrode est reliée par une connexion 64 au manchon 61 et à une masse 65 qui est celle du guide 300. La pièce 62 comporte également une extrémité 621 munie d'un plot 622 destiné à l'extraction du signal de fréquence intermédiaire $S_{FI}$.

Un dispositif analogue est utilisé pour le module oscillateur local, une source d'alimentation continue étant alors insérée entre le plot de connexion de la pièce 63 et la masse du guide.

Dans cette variante, il n'est plus nécessaire d'utiliser le circuit imprimé 15 et l'on peut se dispenser de pratiquer des ouvertures latérales dans le guide 300.

Il y a lieu de noter que la connexion 64 ne constitue pas une dérivation génante vers la masse de la tension haute fréquence, cela en raison de sa grande impédance dûe à la finesse du fil utilisé pour réaliser la connexion 64 (longueur de l'ordre du millimètre, diamètre de l'ordre du 1/100 de millimètre).

Parmi les avantages non encore mentionnés de l'invention, on doit signaler le fait que l'oscillateur local à la fréquence moitié de celle du signal ne peut rayonner sur les voies réservées au signal par le guide d'ondes unique, car celui-ci ne peut pas transmettre, en raison de ses dimensions, une longueur d'onde double (celle du signal local) de celle pour laquelle il a été construit.

7

## REVENDICATIONS

1. Mélangeur subharmonique pour récepteur en ondes millimétriques du type comportant dans un guide d'ondes unique véhiculant le signal à recevoir, un oscillateur local et un organe mélangeur à deux diodes semiconductrices en montage antiparallèle, un couplage capacitif existant entre l'organe mélangeur et l'oscillateur local et des moyens de raccordement avec l'extérieur du guide assurant la sortie du mélangeur et l'alimentation de l'oscillateur local et de l'organe mélangeur, proprement dit, ledit mélangeur subharmonique étant caractérisé en ce que l'oscillateur local est réalisé sous la forme d'un premier module comportant un support conducteur, une diode semiconductrice à résistance négative dont une électrode est en contact avec le support du premier module et dont l'autre électrode est en contact avec une métallisation s'étendant sur un matériau diélectrique placé sur le support et entourant la diode, et que l'organe mélangeur est réalisé sous la forme d'un deuxième module comportant un support conducteur, les deux diodes semiconductrices en montage antiparallèle, celles-ci ayant chacune une électrode en contact avec le support du deuxième module et l'autre électrode en contact avec une métallisation s'étendant sur un matériau diélectrique placé sur le support et entourant les diodes.

2. Mélangeur suivant la revendication 1, caractérisé en ce que les diodes semiconductrices du deuxième module sont du type Schottky, la diode du premier module étant du type Gunn ou à avalanche.

3. Mélangeur suivant la revendication 1, caractérisé en ce que les métallisations des modules sont en contact mécanique et électrique avec les deux faces métallisées d'un même circuit imprimé, celui-ci faisant partie des moyens de raccordement avec l'extérieur du guide.

8

4. Mélangeur suivant la revendication 1, caractérisé en ce que chaque module est inclus dans un dispositif comportant un manchon relié à la masse du récepteur, entourant une pièce métallique centrale sur laquelle est monté le support du module, la pièce étant isolée du manchon et comportant une extrémité opposée au module et munie d'une connexion avec les moyens de raccordement.

5. Mélangeur suivant la revendication 1, caractérisé en ce que les supports des modules traversent le guide d'ondes sur deux faces opposées de celui-ci et que les moyens de raccordement traversent le guide en d'autres points.

6. Mélangeur suivant la revendication 4, caractérisé en ce que les supports des modules traversent le guide d'ondes sur deux faces opposées de celui-ci et que les moyens de raccordement utilisent la pièce centrale du dispositif contenant chaque module.

7. Récepteur utilisant un mélangeur suivant l'une quelconque des revendications 1 à 6, caractérisé en ce qu'il comporte :
- une antenne de réception en ondes millimétriques ;
- un guide d'onde contenant le mélangeur ;
- un filtre de fréquence intermédiaire ;
- un amplificateur de fréquence intermédiaire ;
- des moyens de détection du signal à basse fréquence d'amplification.

# FIG.1

# FIG.2

# FIG.3

# FIG.4

541      15      543      $S_{FI}$

542

141

14

# FIG.5

51

60 11 12    64

65

31

61

63

62

621

622

S

Office européen
des brevets

**RAPPORT DE RECHERCHE EUROPEENNE**

| Catégorie | Citation du document avec indication, en cas de besoin, des parties pertinentes | Revendication concernée |
|---|---|---|
| | **DOCUMENTS CONSIDERES COMME PERTINENTS** | |
| E | EP - A - 0 021 872 (THOMSON-CSF)  *en entier* | 1,4,8 |
| P,D | FR - A - 2 452 201 (THOMSON-CSF)  *en entier*  & EP - A - 0 016 695 | 1 |
| A | GB - A - 2 010 036 (HITACHI)  * page 1, ligne 92 - page 2, ligne 60; figures 1A, 1B, 2A, 2B * | 1 |
| A | DE - A - 2 215 525 (LICENTIA)  * page 3, ligne 8; page 5, ligne 9; figure unique * | 1,2,7 |
| A | US - A - 3 980 974 (YAMAMOTO et al)  * colonne 2, ligne 6 - colonne 6, ligne 32; figures 1,2,4,5,6,10* | 1,7 |

**CLASSEMENT DE LA DEMANDE (Int. Cl. 3)**

H 03 D 9/06
H 04 B 1/26

**DOMAINES TECHNIQUES RECHERCHES (Int. Cl. 3)**

H 03 D 9/06
      9/00
      9/02
      7/02
      7/14
H 03 F 7/04
H 04 B 1/28
H 03 B 9/14
H 04 B 1/26

**CATEGORIE DES DOCUMENTS CITES**

X: particulièrement pertinent

A: arrière-plan technologique

O: divulgation non-écrite

P: document intercalaire

T: théorie ou principe à la base
   de l'invention

E: demande faisant interférence

D: document cité dans
   la demande

L: document cité pour d'autres
   raisons

&: membre de la même famille,
document correspondant

Le présent rapport de recherche a été établi pour toutes les revendications

| Lieu de la recherche | Date d'achèvement de la recherche | Examinateur |
|---|---|---|
| La Haye | 7-04-1981 | DHONDT |

OEB Form 1503.1  06.78